(19) Europäisches Patentamt / European Patent Office / Office européen des brevets

(11) **EP 2 297 262 B1**

(12) **EUROPEAN PATENT SPECIFICATION**

(45) Date of publication and mention
of the grant of the patent:
**21.12.2016 Bulletin 2016/51**

(21) Application number: **08773016.4**

(22) Date of filing: **03.07.2008**

(51) Int Cl.:
*C09J 9/02* $^{(2006.01)}$   *C09J 11/04* $^{(2006.01)}$
*C09D 5/24* $^{(2006.01)}$   *H01B 1/22* $^{(2006.01)}$
*C09J 133/08* $^{(2006.01)}$   *C09J 163/00* $^{(2006.01)}$
*C09J 175/04* $^{(2006.01)}$   *C09J 183/04* $^{(2006.01)}$

(86) International application number:
**PCT/CN2008/001269**

(87) International publication number:
**WO 2010/000096 (07.01.2010 Gazette 2010/01)**

(54) **SILVER COATED FLAKY MATERIAL FILLED CONDUCTIVE CURABLE COMPOSITION AND THE APPLICATION IN DIE ATTACH**

MIT SILBERBESCHICHTETEM SCHUPPENFÖRMIGEN MATERIAL GEFÜLLTE LEITFÄHIGE HÄRTBARE ZUSAMMENSETZUNG UND VERWENDUNG BEIM DIE-ATTACH

COMPOSITION CONDUCTRICE DURCISSABLE CONTENANT UN MATÉRIAU EN PAILLETTES À REVÊTEMENT D'ARGENT ET SON UTILISATION POUR LA FIXATION DES PUCES

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**23.03.2011 Bulletin 2011/12**

(73) Proprietor: **Henkel IP & Holding GmbH**
**40589 Düsseldorf (DE)**

(72) Inventors:
• **KONG, Hao**
**Shanghai 200131 (CN)**
• **WANG, Minghai**
**Shanghai 200131 (CN)**

(74) Representative: **Henkel IP Department**
**c/o Henkel AG & Co. KGaA**
**Henkelstraße 67**
**40589 Düsseldorf (DE)**

(56) References cited:
**EP-A1- 1 887 583      WO-A1-2008/031015
CN-A- 1 699 492      CN-A- 101 081 969
GB-A- 2 115 396      JP-A- 2004 063 445
JP-A- 2004 063 446      JP-A- 2004 068 111
US-A- 4 548 862      US-A- 5 840 432
US-A- 6 013 203      US-A- 6 013 203
US-A1- 2002 190 242      US-A1- 2006 145 125**

• WU YI-PING ET AL.: 'Research of Silver Plating Copper Filled Conductive Adhesive.' ELECTRONIC COMPONENTS & MATERIALS. no. 4, April 2005, pages 32 - 35, XP008141874

## Description

### Field of the Invention

This invention relates to a conductive curable composition filled with silver coated material, and more particularly, to an organic curable composition comprising micron meter scale fine silver coated material with flaky shape, their application in die attach, and a method for preparing the same.

### Background Arts of the Invention

As a method to form an electrical and/or thermal conductive adhesive applied in an electrical circuit board or a printing wire board or metal pad for semiconductor packaging industry, together with an organic or inorganic binder, thermal and/or electrical conductive filler is used as the media to conduct electron or heat. Metals, inorganic oxides, and some high conductive compounds in particle form are the common fillers, by which, the adhesive can be liquid state to meet the various particular applications. Noble metals such as silver are the major choice. However, silver fillers are expensive. It has been desired to develop, as a substitute, an electrically/thermally conductive composition using an inexpensive material, such as copper and glass, as the core material and coated with a thin layer of silver on its surface as low cost conductive fillers to replace pure silver filler. The replacement of silver by silver coated low cost fillers to develop conductive materials recently became an area of interest in some areas of the electronic industry, such as conductive die-attach adhesives.

JP09296158A discloses a conductive adhesive obtained by mixing and dispersing conductive metal powder and silver-coated glass powder as conductive fillers into a thermosetting or thermoplastic resin, wherein the silver-coated glass powder preferably comprises 20-80wt.% of the conductive fillers and the preferable characteristics of the conductive metal powder comprise a flaky or spherical particle shape. Furthermore, JP2005079251A discloses a resin paste for semiconductor comprising a thermosetting resin, a hardening agent, and a filler containing glass beads which are metal-plated at the surface thereof in the average gain size of 1.0 to 50 micrometer and 5 wt. % or more of the materials. In these two inventions, the silver coated glass is either in a minor amount present in the filler (in JP2005079251A, >5% of the filler, 13% and 18% in example), or not in a flaky shape.

With average particle diameter from 1 to 25 $\mu$m, silver coated copper particles have been used in composition as conductive filler for some years. In 1995, JP07138549A disclosed a conductive composition with 75-90% by weight metal (e.g. 1-20% Ag) coated Cu powder with spherical shape, and into epoxy binder. And in 1999, JP11092739A /JP11092626A also published the application of spherical silver coated copper powder application in conductive composition, which contains the conductive filler combined by silver coated copper and pure silver powder with total amount of 75-97% by weight. The resin is epoxy and acrylate. Later, from 2004 to 2006, JP2004047418A, JP2004063445A and JP2004063446A disclosed the conductive composition using conductive filler also combined with Ag coated Cu and pure silver powder. And further more, JP2004063445A and JP2004063446A talked about 3-20% flat-like silver covering copper powder. To summarize, the above mentioned fillers mostly are either only roughly spherical silver coated copper powder, or the combination of roughly spherical silver coated copper powder with pure silver powder. And only a little flat-like silver coated copper powder (3-20%) could be used. Since the application requirement of such composition is not at the very high end, the filler and their combination has been adequate.

For conductive semiconductor die attach adhesive, the unique requirement has made it a unique type of adhesive. At first, high speed needle dispensing method requires the adhesive to be a fluid with proper range of rheology at the application temperature. Physical stability in storing is also critical, e.g. no settling.

The majority of spherical silver coated copper powder filled composition may be suitable for other application. However, such spherical powder and combination can not be used as die attach adhesive. In the low viscosity, high thixotropic index (TI) system (by Brookfield cone/plate viscometer with spindle type CP-51 to measure viscosity at 0.5 rpm and 5 rpm rotation rate, viscosity = 4,000 ~ 40,000 cP at 25°C, 5 rpm, TI (0.5/5) =1.3 ~ 7) application, the spherical silver coated copper powder tends to settle to the bottom when storing, and the TI is always lower than the requirement. In a word, the majority spherical silver coated copper powder is not the right filler.

Thus, in the prior art, there exists a need for a conductive curable composition with desired workability as dispensable die attach adhesive with a proper range of rheology, viscosity, physical stability in storing and the like.

### Summary of the invention

One of the objects of the present invention is to provide a semiconductor packaging applicable conductive composition using silver coated material flakes as a conductive filler, curable epoxy, acrylate, bismaleimide chemical, or the like or their combination as organic resin, and the method for preparing the same. The composition is capable of showing desired workability as dispensable die attach adhesive with right range of rheology, viscosity and physical stability in storing, being excellent in reliability of conductivity or corrosion resistance, and reducing the amount of high price silver in composition.

In one embodiment, the present invention provides a curable die attach composition comprising conductive filler and a resin, wherein the conductive filler comprises silver coated material flake filler, and is a silver coated copper flake filler or a silver coated glass flake filler, and wherein the silver coated material flake filler is in an amount of 30% or more by weight of the conductive filler, and wherein the loading of the conductive filler is from 30% to 86% by weight of the composition, and wherein the loading of the resin is from 1% to 60% by weight of the composition.

In one preferred aspect, the silver coated material flake filler is a silver coated copper flake filler. The silver coated copper flake filler may be in an amount of 40% or more by weight of the conductive filler. The loading of the conductive filler may be from 30% to 86% by weight of the composition.

In another preferred aspect, the silver coated material flake filler is a silver coated glass flake filler. The silver coated glass flake filler may be in an amount of 30% or more by weight of the conductive filler.

In some embodiments, the conductive filler including the silver coated material flake filler may be treated with a fatty acid.

In one aspect, the silver coated material flakes may have an average diameter preferably from 0.001 $\mu$m to about 100 $\mu$m, more preferably from 1 $\mu$m to about 50 $\mu$m, most preferably from 2 $\mu$m to about 25 $\mu$m. In one aspect, the preferred aspect ratio (diameter/thickness) of the silver coated material flake is from 200 to 2, more preferably from 150 to 2.5, most preferably from 100 to 3. In one aspect, the plated silver coating layer by weight is preferably in the range of from 1% to 70%, more preferably from 1% to 50%, still more preferably from 3% to 40%, and most preferably from 5% to 30%. The silver coated material flake filler is a silver coated copper flake or a silver coated glass flake. The silver coated copper flakes may comprise a silver coating content from 1% to 50% by weight.

In a further aspect, the composition may also comprise a resin and optionally a hardener or curing agent. The resin may be a monomer, oligomer, or polymer organic resin which can be cured or polymerized by chemical or by physical methods, or any combination thereof. The loading of the resin may be from 1% to 60% by weight of the composition. The hardener or curing agent may be in an amount of from 0.01% to 20% by weight of the composition.

In one aspect, the present invention provides a curable composition, comprising a conductive filler in an amount of from 30% to 86% by weight of the composition, with a silver coated material flake filler being 30% or more (up to 100%) by weight of the conductive filler; a resin in an amount of from 1% to 60% by weight of the composition; and a hardener in an amount of from 0.01% to 20% by weight of the composition. The silver coated material flake filler is a silver coated copper flake or a silver coated glass flake.

In a still further aspect, the curable composition according to the invention may further includes other functional ingredient(s). The functional ingredients include without limitation non-conductive fillers, solvents, radical initiator, catalysts, oligomers, antibleed agents, adhesion promoters, antioxidants, conductivity promoters, or the like, or any combination thereof.

The curable composition according to the invention shows a preferred viscosity range (by Brookfield rheometer at 25°C, 5rpm) from 3,000 cP to 80,000 cP, more preferably from 5,000 cP to 50,000 cP, most preferably from 5,000 cP to 35,000 cP. The value called as thixotropic index (T.I., the ratio of viscosity at 0.5 rpm/viscosity at 5rpm, 25°C) range can be from 1.3 to 8, more preferably from 1.5 to 7, most preferably from 2 to 6.

In one embodiment, the present invention provides a method for preparing a curable composition for die attach according to the invention, comprising applying a conductive filler part into a resin part, wherein the conductive filler part comprises a silver coated material flake filler in an amount of from 30% to 100% by weight of the conductive filler. In one aspect, the loading of the conductive filler part is from about 30% to 86% by weight of the curable composition. In a further aspect, the resin part also comprises a hardener. The silver coated material flake filler is a silver coated copper flake or a silver coated glass flake.

In one embodiment, the present invention provides a method for producing an article with a component bonded to a substrate, the method comprising applying a curable die attach composition according to the present invention onto at least a part of the substrate surface, and bonding the component to the coated substrate surface.

In one aspect, the method may further comprise a step of thermally curing the composition at a temperature above room temperature, the step being performed after contacting the substrate with the adhesive. In another aspect, the component bonded to a substrate may be a semiconductor component. In another embodiment, the invention provides an article produced by the method, the article comprising a substrate, a component on the substrate and the composition in accordance with the present invention by which the component bonded to the substrate. The component may be a semiconductor component.

## A Brief Description of the Figures

**Figure 1.** A schematic view of a silver coated copper flake.

**Figure 2.** A schematic view of a semiconductor package using die attach adhesive.

**Figure 3.** A schematic view of a way to dispense die attach adhesive on substrate or die.

**Figure 4.** A shape comparison on spherical filler and flaky filler. The shape difference can result in various rheology performance in die attach adhesive.

**Detailed Description of the Invention**

Unless defined otherwise herein, all technical and scientific terms used herein have the same meaning as commonly understood by one of ordinary skill in the art to which this invention pertains. Although any methods and materials similar or equivalent to those described herein may find use in the practice of the present invention, the preferred methods and materials are described herein. Accordingly, the terms defined immediately below are more fully described by reference to the Specification as a whole. Also, as used herein, the singular "a", "an" and "the" includes the plural reference unless the context clearly indicates otherwise. Numeric ranges are inclusive of the numbers defining the range.

**Definitions**

As used herein, the term "flake", "flaky" or "flaky shape" refers to a flat thin piece or layer, which has a 3rd-dimension size much smaller than the other two dimensions, and may be in regular or irregular shape. The "flake" has micrometer scale fine silver as coating material and a matter as core material such as copper, or glass. In the context of the present invention, the flake shape conductive filler has the advantages of capable of achieving right rheological property for dispensing (higher TI), and obtaining better conductivity, without settling, compared to the roughly spherical powder.

As used herein, the term "conductive filler" may comprises one or more silver coated material flake filler with or without any other conductive filler such as silver, copper, alloy, or the like, or any combination thereof. The shape of the conductive filler is not limited.

As used herein, the term "resin" refers to a curable monomer, oligomer, or polymer resin.

As used herein, the term "RH" or "resin part" refers to a part essentially consisting of resin and hardener, which may further comprise other functional ingredients if necessary according to intended applications, such as non-conductive fillers, solvents, radical initiator, catalysts, oligomers, anti-bleed agents, adhesion promoters, antioxidants, conductivity promoters, or the like, or any combination thereof. That is to say, the term "RH" may refer to a part comprising all the other components other than the conductive filler/fillers in the curable composition.

As used herein, the terms "hardener" and "curing agent" may be used interchangeably.

**Detailed Description**

This invention is to provide a conductive curable composition used in semiconductor packaging, comprising silver coated material having a flake shape as a conductive filler, curable epoxy, or acrylate, or bismaleimide monomer and/or oligomer or their combination as organic resin, and optionally a hardener, and the method for preparing the same. The composition is capable of showing desired workability as dispensable die attach adhesive with a right rang of rheology, viscosity and physical stability in storing, being excellent in reliability of conductivity or corrosion resistance, and reducing the amount of high price silver in composition. Furthermore, with flake shape, the conductive filler can achieve better conductivity with same loading as in spherical powder form, and do not have the settling issue, which easily occurred in the case of those in spherical powder form.

In one embodiment, the present invention provides a curable composition for die attach comprising conductive filler, wherein the conductive filler comprises a silver coated material flake filler. The silver coated material is copper or glass.

In some embodiments, the silver coated material flake filler may be in an amount of 30% or more (up to 100%) by weight of the conductive filler. In a further aspect, the loading of the conductive filler is from about 30% to about 86% by weight of the composition. The silver coated material is copper or glass.

In one aspect, the silver coated material flakes have an average diameter preferably from 0.001 $\mu$m to 100 $\mu$m, more preferably from 1 $\mu$m to 50 $\mu$m, most preferably from 2 $\mu$m to 25 $\mu$m. In another aspect, the preferred aspect ratio (diameter/thickness) of the silver coated material flake is from 200 to 2, more preferably from 150 to 2.5, most preferably from 100 to 3. In still another aspect, the plated silver coating layer by weight is preferably in the range of from 1% to 70%, more preferably from 1% to 50%, still more preferably from 3% to 40%, and most preferably from 5% to 30%. The silver coated material is copper or glass. The silver coated copper or glass flakes may comprise a silver coating content from 1% to 50% by weight.

In a further aspect, the composition may also comprise a resin and optionally a hardener or curing agent. The resin may be a monomer, oligomer or polymer organic resin which can be cured or polymerized by chemical or by physical methods, or any combination thereof. The loading of the resin by weight may be preferably from 1% to 60%, more preferably from 1% to 40%, most preferably from 1% to 30%. The hardener or curing agent may be in an amount of from 0.01%) to 20% by weight of the composition.

In one aspect, the silver coated material flake filler is to provide a curable composition for die attach, comprising a silver coated material flake filler and one or more other conductive filler other than the silver coated material filler, a resin, and a hardener. The silver coated material flake filler is a silver coated copper flake or a silver coated glass flake.

In a still further aspect, for application purpose, the curable composition according to the invention may further includes other functional ingredient(s). The functional ingredients include without limitation non-conductive fillers, solvents, radical initiator, catalysts, oligomers, anti-bleed agents, adhesion promoters, antioxidants, conductivity promoters, or the like, or any combination thereof.

The curable composition according to the invention shows a preferred viscosity range (by Brookfield rheometer at 25°C, 5rpm) from 3,000 cP to 80,000 cP, more preferably from 5,000 cP to 50,000 cP, most preferably from 5,000 cP to 35,000 cP. The value called as thixotropic index (T.I., the ratio of viscosity at 0.5 rpm/viscosity at 5rpm, 25°C) range can be from 1.3 to 8, more preferably from 1.5 to 7, most preferably from 2 to 6.

In one embodiment, the present invention provides a method for preparing a curable composition for die attach according to the invention, comprising applying a conductive filler part into a resin part, wherein the conductive filler part comprises a silver coated material flake filler in an amount of from about 30% up to 100% by weight of the conductive filler. In one aspect, the loading of the conductive filler part may be from 30% to about 86% by weight of the curable composition. In a further aspect, the resin part also comprises a hardener. The silver coated material flake filler is a silver coated copper flake or a silver coated glass flake.

In one embodiment, the present invention provides a method for producing an article with a component bonded to a substrate, the method comprising applying a curable die attach composition according to the present invention onto at least a part of the substrate surface, and bonding the component to the coated substrate surface. As used herein, the term "substrate" may mean a substrate for a semiconductor die or the semiconductor die itself, such as those would occur when two or more dies are arranged in a stacked geometry. In one aspect, the method may further comprise a step of thermally curing the composition at a temperature above room temperature, the step being performed after contacting the substrate with the adhesive. In another aspect, the component bonded to a substrate may be a semiconductor component. In another embodiment, the invention provides an article produced by the method, the article comprising a substrate, a component on the substrate and the composition in accordance with the present invention by which the component bonded to the substrate. The component may be a semiconductor component.

*Resin*

In some embodiments, the resin may be a curable monomer, oligomer, or polymer organic resin. The monomer and/or oligomer may be epoxy monomer and/or oligomer. Exemplary epoxy monomer and/or oligomer contemplated for use in the practice of the present invention include, but not limited to liquid epoxy, liquid epoxy combination, and solid epoxy in solution. For example, the epoxy monomer and/or oligomer may selected from substituted (e.g., amine or hydroxyl substituted) or unsubstituted epoxy, such as, 1,2-epoxypropane, 1,3-epoxypropane, butylene oxide, n-hexyl propylene epoxide or the like. Examples of commercially available epoxy monomer(oligomer) may be Araldite DY 027 (Chemica Inc. 316 West 130th Street, Los Angeles, CA, 90061, USA), Cardula N-10 (Vantlco Inc., 281 Fields Lane, Brewster, NY 10509, USA), Epiclon EXA-830CRP (from DIC Corporation, Japan), or the combination thereof.

In other embodiments, the monomer and/or oligomer may be (meth)acrylate monomer and/or oligomer. The (meth)acrylate monomer and/or oligomer contemplated for use in the practice of the present invention include, but not limited to liquid (meth)acrylate, liquid (meth)acrylates combination and solid (meth)acrylate monomer(oligomer) in solution. For example, the (meth)acrylate monomer and/or oligomer may be selected from methyl (meth)acrylate, ethyl (meth)acrylate, propyl (meth)acrylate, butyl (meth)acrylate, ethyl hexyl (meth)acrylate, isobutyl acrylate or the like. Examples of commercially available (meth)acrylate monomer(oligomer) may be SR248, SR355, or their combination (commercially available from Sartomer Inc. (Shanghai), 500 Fu Te 2nd East Road, Wai Gao Qiao Free Trade Zone, Shanghai, 200131).

In some embodiments, the monomer and/or oligomer may be cyanate ester monomer and/or oligomer. The cyanate ester may comprise various suitable cyanate ester known in the art, including isocyanates. Suitable cyanates include, for example, ethylene diisocyanate; 1,4-tetramethylene diisocyanate; 1,4 and/or 1,6-hexamethylene diisocyanate; 1,12-dodecane diisocyanate; cyclobutane-1,3-diisocyanate; cyclohexane-1,3- and 1,4-diisocyanate and mixtures of these isomers; 1-isocyanato-3,3,5- trimethyl-5-isocyanatomethyl cyclohexane; 2,4- and 2,6-hexahydrotolylene diisocyanate and mixtures of these isomers; hexahydro-1.,3-and/or 1,4-phenylene diisocyanate; perhydro-2,4'- and/or 4,4'-diphenyl methane diisocyanate; 1,3- and 1,4-phenylene diisocyanate; 2,4- and 2,6-toluene diisocyanate and mixtures of these isomers; diphenyl methane-2,4'- and/or 4,4'-diisocyanate; naphthylene-1,5-diisocyanate; 1,3- and 1,4-xylylene diisocyanate, 4,4'-methylene-bis(cyclohexyl isocyanate), 4,4'-isopropyl- bis(cyclohexyl isocyanate), 1,4-cyclohexyl diisocyanate and 3-isocyanatomethyl-3,5,5-trimethylcyclohexyl isocyanate (IPDI); 2,4- and 2,6-toluene diisocyanate; diphenylmethane diisocyanate; hexamethylene diisocyanate; dicyclohexylmethane diisocyanate; isophorone diisocyanate; 1-methyoxy-2,4-phenylene diisocyanate; 1-chlorophenyl-2,4-diisocyanate; p-(1-isocyanatoethyl)-phenyl isocyanate; m-(3-isocyanatobutyl)-phenyl isocyanate and 4-(2-isocyanate-cyclohexyl-methyl)-phenyl isocyanate, isophorone diisocyanate, toluene diisocyanate and mixtures thereof.

The monomer and/or oligomer may also be silane monomer and/or oligomer. The silanes may include non-functional silanes and functionalized silanes including amino-functional, epoxy-functional, acrylate-functional and other functional silanes, which are known in the art. Exemplary functionalized silanes include r-glycidoxypropyl-trimethoxysilane, γ -glycidoxypropyltriethoxysilane, r-glycidoxypropyl-methyldiethoxysilane, glycidoxypropyltrimethoxysilane, glycidoxypropyltriethoxysilane, glycidoxypropylmethyldimethoxysilane, glycidoxypropylmethyldiethoxysilane, 5,6-epoxyhexyltriethoxysilane, epoxycyclohexylethyltrimethoxysilane, and the like. Other exemplary functionalized silanes include trimethoxysilylpropyldiethylene-triamine, N-methylaminopropyltrimethoxysilane, aminoethylaminopropylmethyldimethoxysilane, aminoethylaminopropyltrimethoxysilane, aminopropylmethyldimethoxysilane, aminopropyltrimethoxysilane, aminoethylaminoethylaminopropyl-trimethoxysilane, N-methylamino-propyltrimethoxysilane, methylamino-propyltrimethoxysilane, aminopropylmethyl-diethoxysilane, aminopropyltriethoxysilane, 4-aminobutyltriethoxysilane, oligomeric aminoalkylsilane, m-aminophenyltrimethoxysilane, phenylaminopropyltrimethoxysilane, aminoethylaminopropyltriethoxysilane, aminoethylaminoisobutylmethyldimethoxysilane, and the like. Additional exemplary functional silanes include (3-acryloxypropyl)-trimethoxysilane, gamma-methacryloxypropyltrimethoxysilane, gamma-mercapto-propyltriethoxysilane, and olefinic silanes, such as vinyltriallcoxysilane, vinyltriacetoxysilane, alkylvinyldialkoxysilane, allyltrialkoxysilane, hexenyltrialkoxysilane and the like.

The monomer(oligomer)s can also be monofunctional monomer(oligomer)s, such as alkoxylated tetrahydrofurfuryl acrylate, 2(2-ethoxyethoxy) ethyl acrylate, stearyl acrylate, lauryl acrylate, issoctyl acrylate, tridecyl acrylate, caprolactone acrylate, lauryl methacrylate, isobonyl methacrylate; and difunctional monomer(oligomer)s, such as difunctional cyclohexane dimethanol diacrylate, tetraethylene glycol diacrylate, or multiple functional monomer(oligomer)s, such as trimethylolpropane triacrylate, propoxylated glyceryl triacrylate, di-trimethylolpropane tetraacrylate, pentacarylate ester, and so on. (e.g., commercially available from Sartomer Inc. (Shanghai), 500 Fu Te 2nd East Road, Wai Gao Qiao Free Trade Zone, Shanghai, 200131).

*Curing Agents/Hardeners*

The curing agent used in the practice of the present invention may include, for example, Lewis acid, Lewis base, imidazole, anhydride, or the combination thereof. Typically, the curing agent is present in the range of from 0.01% to 20 % by weight of the curable composition.

*Radical initiators*

The radical initiator used in the practice of the present invention may include, but not limited to peroxide, persulphate, azo compound and their combination. The preferred radical initiator may include peroxide, such as methyl ethyl ketone peroxides, tertiary- amyl peroxy-2-ethylhexyl carbonate, tertiary-butyl peroxyacetate, dicumyl peroxide and so on; mostly preferred peroxide is dicumyl peroxide. Typically, the radical initiator is present in the range of 0.01% - 20% by weight of the curing composition, preferably from 0.05% to 5% by weight.

*Anti-bleed Agents*

In one embodiment of the present invention, the curable composition of the invention may comprising an anti-bleed agent. For example, the anti-bleed agent may be a functional fluoride anti-bleed agent, which has the formula R-X, where X is(are) reactive functional group(s), R is a fluoro group containing organic chain, with carbon number from 1 to 100 or more, preferably, from 1 to 20, and preferably X contains a substituted or unsubstituted epoxy, a substituted or unsubstituted amino, a substituted or unsubstituted maleimide group, a substituted or unsubstituted silane group, a substituted or unsubstituted oxane group, or a substituted or unsubstituted cyanate ester group, or the like, or the combination thereof. In one aspect, R may have a formula $CF_3(CF_2)_n$, wherein n is an integer from 1 to about 100 or more; preferably, from 1 to 20; more preferably, from 1 to 16; most preferably, from 1 to 9. Other appropriate anti-bleed agents known in the art may be contemplated in the present invention, for example, alcohols, amides, amines, carboxylic acid, and esters containing two to about twelve carbon atoms (see, e.g., U.S. Pat. No. 4,483,898, issued to Schonborn, et. al. on November 20, 1984, which is incorporated herein by reference).

*Catalysts*

The catalysts used in the practice of the present invention may include, for example, amine catalysts and/or acid catalysts such as lewis acid, lewis base, imidazole, phenol, or the like or the combination thereof. Exemplary amine catalyst may include, but not limited to, primary amine, secondary amine and the combination. The preferred amine catalyst is primary amine, for example, N,N'-(4-methyl-1,3-phenylene)-bis-1-pyrrolidine-carboxamide. Exemplary acid catalyst may include, but not limited to carboxylic acid, acid anhydride and their combination. For example, the acid catalyst may be glutaric acid. Typically, the catalyst is present in the range of from 0.001% to 20 % by weight of the whole bulk resin, preferably from 0.05% to 10 % by weight.

*Other Functional Ingredients*

If desired, the curable composition may further comprise other functional ingredients, for example, conductive fillers other than silver coated material flake, non-conductive fillers, solvents, oligomers, adhesion promoters, antioxidants, conductivity promoters and the like. These ingredients can be appropriately selected from those known ingredients by those skilled in the art depending on the purpose of the application of the curable composition according to the present invention.

**Examples**

For all the examples illustrated below, the mixing process was done by hand-mixing for 5min. If the formulation does not appear uniform by visual observation, another 5min hand mixing will be added. For viscosity measurement, take about 0.5 ml sample and use Brookfield cone/plate viscometer with spindle type CP-51 to measure viscosity at 0.5 rpm and 5 rpm rotation rate respectively. Electrical conductivity is expressed as volume resistivity (VR) and was measured on a glass slide on which a 5 cm by 5 mm track was applied with a thickness in the range from 15 - 200 microns; typical thickness is 30-50 microns. After cure of the material the resistance was measured and the volume resistance was calculated from the equation:

$$VR = R*W*T/L$$

 where R is track resistance in $\Omega \cdot cm$ measured along the length L; W is width of track in centimeters; T is thickness of track in centimeters; L is length of track in centimeters.

**Example E1:**

Mix 30 weight parts of RH of the die attach product Ablebond® 84-1LMISR4 RH(epoxy platform, available from Henkel), numbers listed in Table 1 weight parts of silver coated copper flake filler 600C (available from Ferro Inc.) and silver coated copper spherical filler 19-908 (available from Technic Inc) using the aforementioned mixing process. No other chemical is added in this case. Viscosity and TI of the mixture were tested by Brookfield viscometer. The mixture is then cast into thin film and cured in oven. The film dimension is described above. The curing condition is ramping from 40°C to 175°C in 15min then staying at 175°C for 60min. Settling was tested by visual examination and hand bar feeling after putting the liquid composition on table at RT for 6 hours.

**Table 1:** *Composition (components in parts by weight) and performance test results using resin from commercial products. Viscosity was recorded with a Brookfield HBDV-III ultra C using rotating speed of 0.5 and 5 rpm. The volume resistivity was recorded by four-point probe.*

| Composition component | E1-1 | E1-2 | E1-3 | E1-4 | E1-5 |
|---|---|---|---|---|---|
| 84-1LMISR4 RH* | 30.0% | 30.0% | 30.0% | 30.0% | 30.0% |
| AgCu flake 600C * | 70.0% | 46.7% | 30.0% | 18.7% | |
| AgCu powder 19-908 * | | 23.3% | 40.0% | 51.3% | 70.0% |

(continued)

| Composition component | E1-1 | E1-2 | E1-3 | E1-4 | E1-5 |
|---|---|---|---|---|---|
| Filler cont. wt% | 70.0% | 70.0% | 70.0% | 70.0% | 70.0% |
| Total wt% | 100.0% | 100.0% | 100.0% | 100.0% | 100.0% |
| Vis.@25.0 °C, 0.5rpm(cP) | 144984 | 52194 | 23000 | 11598 | 5799 |
| Vis.@25.0 °C, 5rpm(cP) | 54928 | 18143 | 8118 | 7124 | 4639 |
| Thixotropic Index (0.5/5) | 2.64 | 2.88 | 2.83 | 1.63 | 1.25 |
| Volume Resistivity ($\Omega\cdot$cm) | 2.95E-03 | 2.96E-03 | 2.70E-03 | 6.22E-03 | 5.73E-03 |
| Settle observation | No settle | No settle | No settle | Little settle | Settle |

**Example E2:**

Mix market available chemicals EPICLON 830-S (epoxy, from DIC Inc), MHHPA (Methylhexahydrophthalic anhydride, from Lonza group) and CURIMID CN (1-(2-cyanoethyl)-2-ethyl-4-methylimidazole, from Borregaard Synthesis Co.) by weight parts of in Table 2 using the aforementioned mixing process as the basic RH. Then mix RH with filler to composition and test also using the aforementioned mixing process.

**Table 2:** *Composition (components in parts by weight) and performance test results using epoxy platform test vehicle. Viscosity was recorded with a Brookfield HBDV-III ultra C using rotating speed of 0.5 and 5 rpm. The volume resistivity was recorded by four-point probe test.*

| Composition component | RH | E2-1 | E2-2 |
|---|---|---|---|
| EPICLON 830-S | 55.5% | | |
| MHHPA | 44.4% | | |
| CURIMID CN | 0.1% | | |
| RH wt% | | 25.0% | 25.0% |
| AgCu600C | | 75.0% | |
| 19-908 | | | 75.0% |
| Filler cont. wt% | | 75.0% | 75.0% |
| Total wt% | 100.0% | 1.00 | 1.00 |
| Vis.@25.0 °C, 0.5rpm(cP) | | 53851 | 4142 |
| Vis.@25.0 °C, 5rpm(cP) | | 16900 | 3642 |
| Thixotropic Index (0.5/5) | | 3.19 | 1.14 |
| Volume Resistivity($\Omega\cdot$cm) | | 1.50E+02 | >1E+06 |
| Settle observation, 6 hrs | | No settle | Settle |

**Example E3:**

Mix market available chemicals SRM-1 (from Henkel), SR248 and RICON 131MA10 (from Sartomer Shanghai Ltd.), Dicumy Peroxide (from Sigma-Aldrich Shanghai Ltd.) by weight parts of in Table 3 using the aforementioned mixing process as the basic RH. Then mix RH with silver coated copper filler to composition and test also using the aforementioned mixing process.

**Table 3:** *Composition (components in parts by weight) and performance test results using the combination of acrylate and BMI platforms test vehicle. Viscosity was recorded with a Brookfield HBDV-III ultra C using rotating speed of 0.5 and 5 rpm. The volume resistivity was recorded by four-point probe test.*

| Composition component | RH | E3-1 | E3-2 | E3-3 |
|---|---|---|---|---|
| SRM-1 | 32.0% | | | |
| SR248 | 55.2% | | | |
| RICON 131MA10 | 12.0% | | | |
| Dicumy Peroxide | 0.8% | | | |
| RH wt% | | 20.0% | 20.0% | 17.9% |
| AgCu flake 600C | | 80.0% | | |
| AgCu powder 19-908 | | | 80.0% | 82.1% |
| Filler cont. wt% | | 80.0% | 80.0% | 82.1% |
| Total wt% | 100.0% | 100.0% | 100.0% | 100.0% |
| Vis.@25.0°C, 0.5rpm(cP) | | 7456 | too low | 2485 |
| Vis.@25.0°C, 5rpm(cP) | | 5550 | 1822 | 8199 |
| Thixotropic Index (0.5/5) | | 1.34 | NA | 0.30 |
| Volume Resistivity($\Omega\cdot$cm) | | 4.32E-04 | 1.08E+02 | 3.04E-03 |
| Settle observation, 6 hrs | | No settle | Settle | Settle |

**Example E4:**

Mix 25 weight parts of RH of the die attach product Ablebond® 2100A (available from Henkel.), 50 weight parts of silver coated copper flakes filler 600C (available from Ferro Inc.) and 25 weight parts of pure silver flakes filler SF96 (available from Ferro Inc.) using the aforementioned mixing process, and then test also using the aforementioned mixing process. The VR was recorded with 0.04 $\Omega\cdot$cm. The viscosity was recorded as 11,000 at 5rpm, and TI was 2.85. No settling was identified.

**Example E5:**

Mix market available chemicals EPICLON 830-S (from DIC Inc), MHHPA (from Lonza group) and CURIMID CN (from Borregaard Synthesis Co.) by weight parts of in Table 4 using the aforementioned mixing process as the basic RH. Then mix RH with silver coated glass flakes and spherical filler (from Potter Inc.) to composition and test also using the aforementioned mixing process.

**Table 4:** *Composition (components in parts by weight) and performance test results using epoxy platform test vehicle. Viscosity was recorded with a Brookfield HBDV-III ultra C using rotating speed of 0.5 and 5 rpm. The volume resistivity was recorded by four-point probe test.*

| | | NAME | E5-1 | E5-2 | E5-3 | E5-4 |
|---|---|---|---|---|---|---|
| RH | 830S | | 50 | 50 | 50 | 50 |
| | MHHPA | | 40 | 40 | 40 | 40 |
| | CURIMID CN | | 0.2 | 0.2 | 0.2 | 0.2 |
| | RH content wt% | | 60% | 50% | 60% | 60% |
| Filler | SG05TF40 | Flake | | | 40% | 30% |
| | SG02S40 | Spherical | 40% | 50% | | 10% |
| | Filler content wt% | | 40% | 50% | 40% | 40% |
| *Properties* | | | | | | |
| Viscosity@25°C, 5rpm | | cP | 1988 | 6213 | 12261 | 9527 |
| T.I. | | | 1.25 | 1.6 | 2.4 | 2.08 |
| Volume Resistivity | | Ω·cm | 712.47 | 0.00629 | 0.00261 | 0.01306 |
| Settling | | | Yes | Yes | No | No |

Silver coated copper flake 600C and spherical powder 19-908 were purchased from suppliers Ferro Inc. and Technic Inc., respectively. The particle size in terms of diameter is all at the same level with D50 at 15~20 um.

From the comparing results between sphere silver coated copper powder and silver coated copper flake particles, the conclusion is, silver coated copper flake must be the essential filler for the application in die attach adhesive.

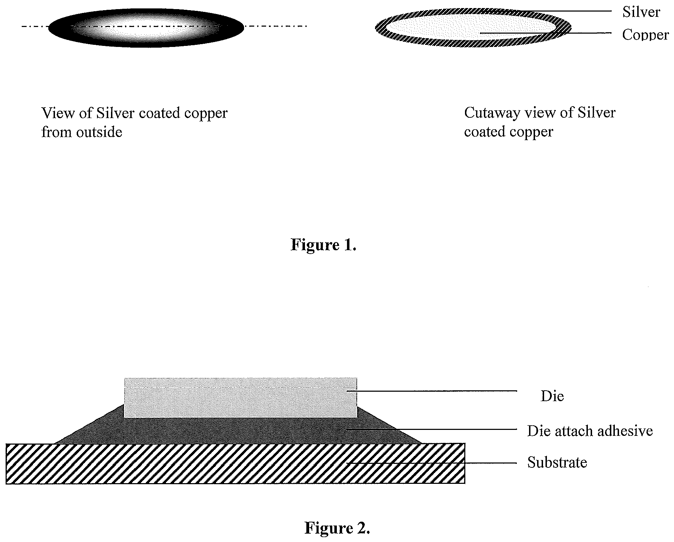

Figure 2 shows where the die attach adhesive is used. In semiconductor packages, die attach means to attach functionalized semiconductor die onto metal or printed circuit board (PCB) substrates by means of film, paste, solder and so on. Among them, die attach adhesive is the major.

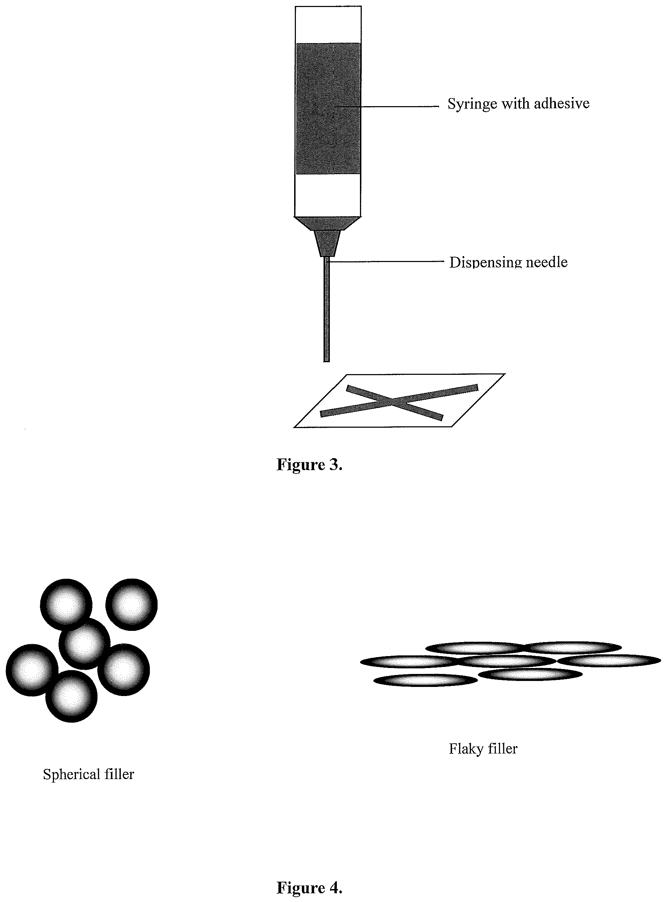

Dispensing adhesive by syringe needle onto substrate or die (Figure 3) is atypical method on die attach. To dispense well, the liquid adhesive has to show the proper range of viscosity and rheology.

Particle shape can make an important role to get the desired viscosity and rheology range (Figure 4). In theory, spherical particle has not obvious effect to adjust viscosity and rheology.

Particularly for silver coated copper flakes, with the limitation on aspect ratio in making such products, and the surface treatment, the viscosity and rheology adjustment are tricky.

Silver coated copper flake particles are used in experiments to bring the die attach adhesive right rheology and conductivity for needle dispensing requirement. The experiments herein showed the results. And the data comparison between spherical silver coated copper powder and silver coated copper flake particles also demonstrated the silver coated copper flake particle work better than spherical counterpart in terms of rheology and conductivity, particularly, the rheology.

In table 1, example E1-1, with addition of 70 % pure silver coated copper flake 600C, the viscosity and rheology performance make the adhesive usable as die attach adhesive. The conductivity by volume resistivity has been very low, with the filler loading not high for conductive adhesive. By the way, the liquid adhesive is stable with time, without settling observation in 6 hours at room temperature. In a word, the silver coated copper flakes particle 600C can be the conductive filler for a conductive, dispensable die attach adhesive.

In example E1-2, E1-3, and E1-4, the combination of flake and powder was used as conductive filler. With flaky filler in formulation, the sample rheology is also acceptable for die attach adhesive in E1-2 and E1-3. While in E1-4, the majority filler is spherical powder, although the rheology is still in the range, but the filler settling has been identified. And in E1-5, all the filler settled on the bottom if liquid adhesive, and the rheology is also not acceptable for dispensable die attach adhesive. So one of the conclusions is reached that a flaky filler is more effective to bring proper rheology to adhesive and does not result in settling.

From E1-1 to E1-4, the adhesive viscosity has dropped a lot. Although to increase filler content is a way to resolve low viscosity problem, to apply flaky filler is better considering on cost and other performance, proper modulus, for instance.

Example E2 series were used to differentiate the conductivity difference between flaky and spherical silver coated copper filler. In this test vehicle, with 75% flaky filler, the volume resistivity is 150 $\Omega$·cm in E2-1. However, with only 75% spherical silver coated copper powder, the volume resistivity could not be detected, which means the conductivity is very low in E2-2. So, silver coated copper flake is more conductive than spherical silver coated copper in the comparable test vehicle. By the way, the rheology of E2-1 is in the range for die attach adhesive, while that of E2-2 is out.

Another platform test vehicle was also used to tell the difference between the shapes in Example E3 series. In a low viscosity test vehicle, the rheology of E3-1 is not ideal, but it is still on the border. E3-2 is powder filler sample. The thixotropic index could not be told by means of Brookfield rheometer. The conductivity of the two different shape silver coated copper filler sample is also in variety. The volume resistivity of E3-1 is 0.000432 $\Omega$·cm, while E3-2 108 $\Omega$·cm, 250,000 times higher.

From the results discussion above, in a word, rheology performance showed by silver coated copper flakes can be the major reason why the inventors choose it as the main conductive filler in die attach adhesive. The rheology performance from spherical silver coated copper powder is on the low end, or on the opposite side.

## Claims

1. A curable die attach composition comprising conductive filler and a resin, wherein the conductive filler comprises silver coated material flake filler, and is a silver coated copper flake filler or a silver coated glass flake filler, and wherein the silver coated material flake filler is in an amount of 30% or more by weight of the conductive filler, and wherein the loading of the conductive filler is from 30% to 86% by weight of the composition, and wherein the loading of the resin is from 1% to 60% by weight of the composition.

2. The composition of claim 1, wherein the silver coated copper flake filler is in an amount of 40% or more by weight of the conductive filler.

3. The composition according to claim 1 or 2, wherein the silver coated material flakes have an average diameter from 0.001 $\mu$m to 100 $\mu$m.

4. The composition of any one of the preceding claims, wherein the silver coated material flakes have an aspect ratio ranging from 200 to 2.

5. The composition of any one of the preceding claims, having a viscosity range from 3,000 cP to 80,000 cP.

6. The composition of any one of the preceding claims, having a thixotropic index from 1.3 to 8.

7. A method for producing an article with a component bonded to a substrate, the method comprising applying a curable composition of any of claims 1-6 onto at least a part of the substrate surface, and bonding the component to the coated substrate surface.

## Patentansprüche

1. Aushärtbare Die-Attach-Zusammensetzung, umfassend einen leitenden Füllstoff und ein Harz, wobei der leitende Füllstoff silberbeschichteten Materialflockenfüllstoff umfasst und ein silberbeschichteter Kupferflockenfüllstoff oder ein silberbeschichteter Glasflockenfüllstoff ist und wobei der silberbeschichtete Materialflockenfüllstoff in einer Menge von wenigstens 30 Gew.-% des leitenden Füllstoffs vorliegt und wobei die Beladung in dem leitenden Füllstoff von 30 Gew.-% bis 86 Gew.-% der Zusammensetzung ausmacht und wobei die Beladung in dem Harz von 1 Gew.-% bis 60 Gew.-% der Zusammensetzung ausmacht.

2. Zusammensetzung nach Anspruch 1, wobei der silberbeschichtete Kupferflockenfüllstoff in einer Menge von mindestens 40 Gew.-% des leitenden Füllstoffs vorliegt.

3. Zusammensetzung nach Anspruch 1 oder 2, wobei die silberbeschichteten Materialflocken einen durchschnittlichen Durchmesser von 0,001 $\mu$m bis 100 $\mu$m aufweisen.

4. Zusammensetzung nach einem der vorhergehenden Ansprüche, wobei die silberbeschichteten Materialflocken ein Seitenverhältnis von 200 bis 2 aufweisen.

**5.** Zusammensetzung nach einem der vorhergehenden Ansprüche mit einem Viskositätsbereich von 3.000 cP bis 80.000 cP.

**6.** Zusammensetzung nach einem der vorhergehenden Ansprüche mit einem thixotropen Index von 1,3 bis 8.

**7.** Verfahren zum Herstellen eines Erzeugnisses mit einer an ein Substrat geklebten Komponente, wobei das Verfahren umfasst: das Aufbringen einer aushärtbaren Zusammensetzung nach einem der Ansprüche 1-6 auf wenigstens einen Teil der Substratoberfläche und das Verkleben der Komponente mit der beschichteten Substratoberfläche.

**Revendications**

**1.** Composition durcissable de fixation de puce contenant une charge conductrice et une résine, la charge conductrice comprenant une charge de paillettes de matière revêtue d'argent, et est une charge de paillettes de cuivre revêtu d'argent ou une charge de paillettes de verre revêtue d'argent, et la charge de paillettes de matière revêtue d'argent étant dans une quantité de 30% en poids ou plus de la charge conductrice, et l'imprégnation de la charge conductrice étant de 30% à 86% en poids de la composition, et l'imprégnation de la résine étant de 1% à 60% en poids de la composition.

**2.** Composition selon la revendication 1, dans laquelle la charge de paillettes de cuivre revêtue d'argent est dans une quantité d'au moins 40% en poids ou plus de la charge conductrice.

**3.** Composition selon la revendication 1 ou 2, dans laquelle les paillettes de matière revêtue d'argent ont un diamètre moyen de 0,001 $\mu$m à 100 $\mu$m.

**4.** Composition selon l'une quelconque des revendications précédentes, dans laquelle les paillettes de matière revêtue d'argent ont un rapport d'aspect de 200 à 2.

**5.** Composition selon l'une quelconque des revendications précédentes, ayant une gamme de viscosités de 3000 cP à 80000 cP.

**6.** Composition selon l'une quelconque des revendications précédentes, ayant un indice thixotropique de 1,3 à 8.

**7.** Procédé de production d'un article pourvu d'un composant lié à un substrat, le procédé comprenant les étapes suivantes consistant à appliquer une composition durcissable selon l'une quelconque des revendications 1 à 6 sur au moins une partie de la surface du substrat, et à relier le composant à la surface revêtue du substrat.

View of Silver coated copper
from outside

Cutaway view of Silver
coated copper

**Figure 1.**

**Figure 2.**

Syringe with adhesive

Dispensing needle

**Figure 3.**

Spherical filler

Flaky filler

**Figure 4.**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 09296158 A
- JP 2005079251 A
- JP 07138549 A
- JP 11092739 A
- JP 11092626 A
- JP 2004047418 A
- JP 2004063445 A
- JP 2004063446 A
- US 4483898 A, Schonborn